# EUROPÄISCHE PATENTSCHRIFT

(11) **EP 4 260 352 B1**
(45) Veröffentlichungstag und Bekanntmachung des Hinweises auf die Patenterteilung: **05.03.2025**
(21) Anmeldenummer: 21830658.7
(22) Anmeldetag: 06.12.2021
(51) Int. Cl.: H01H 1/00, H01H 9/54, H01H 47/00, G01R 31/327

(54) **VERFAHREN ZUR ERKENNUNG DES SCHALTZUSTANDS EINES ZUMINDEST EIN KONTAKTPAAR AUFWEISENDEN SCHALTKONTAKTS EINER ELEKTROMECHANISCHEN SCHALTVORRICHTUNG SOWIE ELNE SCHALTUNGSANORDNUNG ZUR ERKENNUNG DES SCHALTZUSTANDS**
METHOD FOR IDENTIFYING THE SWITCH STATE OF A SWITCH CONTACT OF AN ELECTROMECHANICAL SWITCHING DEVICE, WHICH SWITCH CONTACT COMPRISES AT LEAST ONE CONTACT PAIR, AND A SWITCH ARRANGEMENT FOR IDENTIFYING THE SWITCH STATE
PROCÉDÉ PERMETTANT D'IDENTIFIER L'ÉTAT DE COMMUTATION D'UN CONTACT DE COMMUTATION D'UN DISPOSITIF DE COMMUTATION ÉLECTROMÉCANIQUE, LEQUEL CONTACT DE COMMUTATION COMPREND AU MOINS UNE PAIRE DE CONTACTS, ET AGENCEMENT DE COMMUTATION PERMETTANT D'IDENTIFIER L'ÉTAT DE COMMUTATION

(30) Priorität: 08.12.2020 BE 202005888
(43) Veröffentlichungstag der Anmeldung: 18.10.2023
(73) Patentinhaber: PHOENIX CONTACT GmbH & Co. KG, 32825 Blomberg (DE)
(72) Erfinder: ALTMANN, Matthias, 31812 Bad Pyrmont (DE); LANGER, Tobais, 32657 Lemgo (DE)
(74) Vertreter: LifeTech IP Spies & Behrndt Patentanwälte PartG mbB
(86) Internationale Anmeldenummer: PCT/EP2021/084422
(87) Internationale Veröffentlichungsnummer: WO 2022/122665

(56) Entgegenhaltungen:
- DE-A1- 102013 106 487
- DE-A1- 102018 114 425
- DE-A1- 4 318 188

## Beschreibung

Die vorliegende Erfindung betrifft ein Verfahren zur Erkennung des Schaltzustands eines zumindest ein Kontaktpaar aufweisenden Schaltkontakts einer elektromechanischen Schaltvorrichtung, wobei während einer Betriebsphase zur Erkennung des Schaltzustands der Schaltkontakt mit einem Schaltstrom beaufschlagt wird und der Schaltstrom mittels einer Auswerteeinheit analysiert wird, dahingehend, ob der Schaltkontakt sich in einem geschlossen Schaltzustand oder in einem geöffneten Schaltzustand befindet.

Aus der DE 200 08 548 U1 ist eine Anordnung zur Erkennung der Schaltstellung eines Netzschalters für mikroprozessorgesteuerte Geräte mit Ausschaltverzögerung bekannt. Beschrieben wird ein Netzschalter, der zwei in Reihenschaltung geschaltete Schalter enthält, welche nur gemeinsam geöffnet oder geschlossen werden können, wobei der eine Schalter mit seinem einen Kontakt an einem der beiden spannungsführenden oder (Null-)Leiter und mit seinem anderen Kontakt mit einem ersten Eingang eines Sensors verbunden ist, der bei angelegter Spannung und eingeschaltetem Netzschalter einen Messstrom zum zweiten Eingang des Sensors leitet, der mit dem zugehörigen anderen der beiden spannungsführenden oder (Null-)Leiter verbunden ist. Der Sensor übermittelt dabei ausgangsseitig ein Ausgangssignal entsprechend der Schaltstellung des Netzschalters an einen Mikroprozessor des Gerätes. Aus der DE 10 2018 114425 A1 ist auch eine Schaltüberwachungsvorrichtung bekannt, welche eine Information über den Schaltzustand eines Relaisschaltkontaktes, insbesondere in Abhängigkeit von der Relaisansteuerung bereitstellt.

Der Erfindung liegt die Aufgabe zugrunde ein Verfahren zur Erkennung des Schaltzustands eines Schaltkontakts einer elektromechanischen Schaltvorrichtung sowie eine Schaltungsanordnung zur Erkennung des Schaltzustands eines Schaltkontakts bereitzustellen, wobei die Schaltungsanordnung auf eine verringerte Verlustleistung hin optimiert ist, wodurch ferner ein besseres Wärmemanagement erreicht wird.

Diese Aufgabe wird gelöst durch ein Verfahren zur Erkennung des Schaltzustands eines zumindest ein Kontaktpaar aufweisenden Schaltkontakts einer elektromechanischen Schaltvorrichtung, wobei während einer Betriebsphase zur Erkennung des Schaltzustands der Schaltkontakt mit einem Schaltstrom beaufschlagt wird und der Schaltstrom mittels einer Auswerteeinheit analysiert wird, dahingehend, ob der Schaltkontakt sich in einem geschlossen Schaltzustand oder in einem geöffneten Schaltzustand befindet. Gemäß der Erfindung wird der Schaltkontakt während der Betriebsphase zur Erkennung des Schaltzustands des Schaltkontakts mit einem Schaltstrom beaufschlagt, der als getaktetes Spannungs- oder Stromsignal ausgebildet ist. Hierdurch wird im Gegensatz zu Betriebsverfahren, bei denen während der Zustandserkennung die Schaltkontakte dauerhaft mit einer geforderten Mindestleistung beaufschlagt werden, der Vorteil erzielt, dass die Verlustleitung während der Betriebsphasen, in denen eine Erkennung des Schaltzustands der Schaltkontakte durchgeführt wird, reduziert wird, so dass ein reduzierter Wärmeeintrag innerhalb des Schaltgeräts erfolgt. Dabei ist es dennoch erforderlich, dass die Beaufschlagung der Schaltkontakte mit einer vorgeschriebenen Minimalleistung erfolgt, damit stets eine sichere Kontaktierung gewährleistet werden kann. Etwaige Verunreinigungen an den Schaltkontakten werden dadurch sicher entfernt. Für 24 V-Relais mit Goldkontakten ist beispielsweise eine Leistung von 24 V und 1 mA notwendig. Dabei entsteht Verlustleistung, sowohl an dem Ausgangstreiber als auch an den Relaiskontakten, welche durch das erfindungsgemäße Verfahren sowie durch die erfindungsgemäße Schaltungsanordnung erheblich reduziert werden können.

Weitere vorteilhafte Ausgestaltungen der Erfindung sind in den abhängig formulierten Ansprüchen angegeben. Die in den abhängig formulierten Ansprüchen einzeln aufgeführten Merkmale sind in technologisch sinnvoller Weise miteinander kombinierbar und können weitere Ausgestaltungen der Erfindung definieren. Darüber hinaus werden die in den Ansprüchen angegebenen Merkmale in der Beschreibung näher präzisiert und erläutert, wobei weitere bevorzugte Ausgestaltungen der Erfindung dargestellt werden.

Gemäß der Erfindung wird der Schaltkontakt mit einem Schaltstrom, der als getaktetes Rechtecksignal ausgebildet ist, beaufschlagt. Dabei wird während der Pulsphase ein vorbestimmter maximaler Schaltstrom geschaltet und wird während der Pausenphase ein vorbestimmter minimaler Schaltstrom geschaltet.

Durch ein bevorzugtes Puls-Pausen-Verhältnis von 1:1 wird damit bereits die Verlustleistung als auch der hiermit einhergehende Wärmeeintrag innerhalb des Schaltgeräts erheblich reduziert. Durch eine weitere Verkleinerung der Anschaltzeit kann der Wärmeeintrag weiter reduziert werden. Der minimale Schaltstrom ist mit Vorteil gleich null. Hierdurch sind weitere variierbare Möglichkeiten zur Reduzierung der Verlustleistung ermöglicht.

Der Schaltkontakt wird mit einem Schaltstrom, der als getaktetes Rechtecksignal mit einem variierbaren Puls-Pausen-Verhältnis ausgebildet ist, beaufschlagt. Hierdurch wird die Möglichkeit geschaffen, die Reduzierung der Verlustleistung an entsprechende Rahmenbedingen anpassen zu können.

Bevorzugt kann das Puls-Pausen-Verhältnis in Abhängigkeit von zumindest einem Betriebsparameter variiert werden, so dass die Reduzierung der Verlustleistung direkt wirkgekoppelt werden kann mit der im Schaltgerät erzeugten Verlustleistung während der Schaltzustandserkennung der Schaltkontakte.

Gemäß einer weiteren besonders bevorzugten Ausführungsform der Erfindung kann es vorgesehen sein, dass das Puls-Pausen-Verhältnis voreingestellt wird, derart, dass verschiedene Geschwindigkeiten zur Erkennung des Schaltzustands des Schaltkontaktes vorgebbar sind. Hierdurch ist je nach Einsatzgebiet des Schaltgeräts eine entsprechende Adaption an die Betriebsweise des Schaltgeräts und/oder an die Anforderungen des Kunden und/oder des eingesetzten elektromechanischen Schaltkontakts (bspw. Relais) ermöglicht.

Des Weiteren kann die Erfindung auch dahingehend weiterentwickelt sein, dass die Periodendauer des getakteten Strom- oder Spannungssignals (Testsignals) in Abhängigkeit von zumindest einem Betriebsparameter variiert wird.

In einer ebenfalls bevorzugten Ausgestaltungsvariante der Erfindung kann auch vorgesehen sein, dass bevor der Schaltkontakt mit einem Schaltstrom, der als getaktetes Stromsignal ausgebildet ist, beaufschlagt wird, der Schaltkontakt über eine vorbestimmte Freibrennzeit mit einem nicht getakteten Schaltstrom fester Größe beaufschlagt wird und erst im Anschluss in einen getakteten Modus übergeht. Hierdurch kann erreicht werden, dass eine verbesserte Sauberkeit der Kontakte gewährleistet werden kann, ohne dass unnötig viel Verlustleistung erzeugt wird.

Schließlich wird die der Erfindung zugrunde liegende Aufgabe gelöst durch eine Schaltungsanordnung zur Erkennung des Schaltzustands eines Schaltkontakts einer elektromechanischen Schaltvorrichtung. Die erfindungsgemäße Schaltvorrichtung ist insbesondere zur Durchführung des erfindungsgemäßen Verfahrens geeignet und umfasst eine elektromechanische Schaltvorrichtung mit zumindest einem Schaltkontakt sowie eine Auswerte- und Steuereinheit zur Ansteuerung der elektromechanischen Schaltvorrichtung und zur Auswertung eines durch den Schaltkontakt der elektromechanischen Schaltvorrichtung fließenden Schaltstroms. Erfindungsgemäß ist die Auswerte- und Steuereinheit derart eingerichtet, dass während einer Betriebsphase zur Erkennung des Schaltzustands des Schaltkontakts der Schaltkontakt mit einem als getaktetes Stromsignal ausgebildeten Schaltstrom beaufschlagbar ist und der Schaltstrom analysierbar ist, dahingehend, ob der Schaltkontakt sich in einem geschlossenen Schaltzustand oder in einem geöffneten Schaltzustand befindet.

Die Auswerte- und Steuereinheit umfasst mit Vorteil eine Taktsignalerzeugungseinrichtung, eine Koppeleinheit, und eine Auswerteeinheit, wobei der Schaltkontakt der elektromechanischen Schaltvorrichtung in einem gemeinsamen Pfad zwischen einem Schaltspannungspotential und Masse mit der Taktsignalerzeugungseinrichtung und der Koppeleinheit in Serie geschaltet ist. Die Schaltungsanordnung ist dabei derart eingerichtet, dass in einem Betriebszyklus zur Erkennung des Schaltzustands des Schaltkontakts der Schaltkontakt mit einem als getaktetes Stromsignal ausgebildeten Schaltstrom beaufschlagbar ist, und der im gemeinsamen Pfad fließende Schaltstrom mittels der Auswerteeinheit analysierbar ist, dahingehend, ob der Schaltkontakt sich in einem geschlossen Schaltzustand on oder in einem geöffneten Schaltzustand off befindet.

Gemäß einer weiteren zu bevorzugenden Ausgestaltung des Erfindungsgegenstandes kann vorgesehen sein, dass die Taktsignalerzeugungseinrichtung eine Steuereinheit und einen über die Steuereinheit ansteuerbaren, im Strompfad des Schaltkontakts zu diesem in Serie geschalteten Halbleiterschalter umfasst.

Alternativ kann die Taktsignalerzeugungseinrichtung auch durch einen getakteten stromfesten Signalausgang eines Rechners oder eines Mikroprozessors gebildet sein.

Schließlich kann die Erfindung auch in vorteilhafter Weise dahingehend ausgeführt sein, dass die Koppeleinheit eingerichtet ist, eine Strombegrenzung im Pfad des Schaltkontakts sicherzustellen und den über den Schaltkontakt fließenden getakteten Schaltstrom oder die über dem Schaltkontakt anliegende Spannung zu erfassen und der Auswerteeinheit zuzuführen, so dass in Abhängigkeit von dem erfassten Schaltstromsignal die Zustandserkennung des Schaltkontakts durchgeführt werden kann.

Zusammengefasst beschrieben werden die Relaiskontakte bzw. die Schaltkontakte der elektromechanischen Schaltvorrichtung mit einem getakteten Signal belastet. Der sogenannte high-Level des Signals entspricht dabei der Schaltspannung und dem Schaltstrom, der sogenannte low-Level ist der energiearme bzw. der energielose Zustand. Je nach eingestelltem Puls-Pause-Verhältnis verringert sich die auftretende Verlustleistung pro Periode signifikant im Vergleich zu einem dauerhaften Signal in der gleichen Zeitspanne. Der Ausgangstreiber wird dabei bevorzugt von einem Microcontroller angesteuert und getaktet.

Die Erfindung sowie das technische Umfeld werden nachfolgend anhand der Figuren näher erläutert. Es ist darauf hinzuweisen, dass die Erfindung durch die gezeigten Ausführungsbeispiele nicht beschränkt werden soll. Insbesondere ist es, soweit nicht explizit anders dargestellt, auch möglich, Teilaspekte der in den Figuren erläuterten Sachverhalte zu extrahieren und mit anderen Bestandteilen und Erkenntnissen aus der vorliegenden Beschreibung und/oder Figuren zu kombinieren. Insbesondere ist darauf hinzuweisen, dass die Figuren und insbesondere die dargestellten Größenverhältnisse nur schematisch sind. Gleiche Bezugszeichen bezeichnen gleiche Gegenstände, so dass ggf. Erläuterungen aus anderen Figuren ergänzend herangezogen werden können.

Es zeigen:
- Figur 1: eine Schaltungsanordnung zur Erkennung des Schaltzustands eines Schaltkontakts einer elektromechanischen Schaltvorrichtung in einer möglichen Ausführungsform der Erfindung in schematischer Darstellung, und
- Figur 2: eine im Vergleich zur Ausführungsform gemäß Figur 1 modifizierte Ausgestaltung einer Schaltungsanordnung zur Erkennung des Schaltzustands eines Schaltkontakts einer elektromechanischen Schaltvorrichtung in schematischer Darstellung.

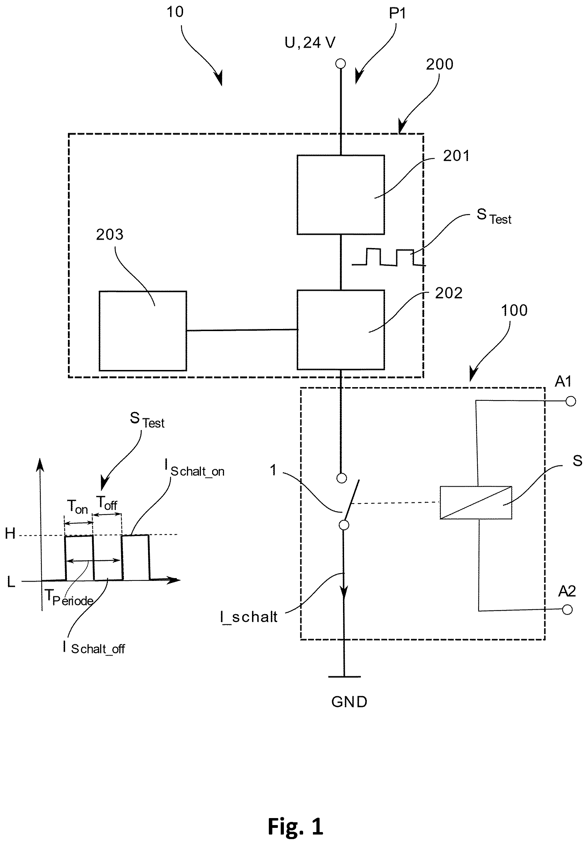

Figur 1 zeigt eine Schaltungsanordnung 10 zur Erkennung des Schaltzustands eines Schaltkontakts 1 einer elektromechanischen Schaltvorrichtung 100 in einer möglichen Ausführungsform der Erfindung in schematischer Darstellung. Die dargestellte Schaltungsanordnung 10 umfasst eine elektromechanische Schaltvorrichtung 100 in Form eines Relais oder eines Schützes oder dergleichen mit einer Spule S, die über zwei Spulenanschlüsse A1, A2 mit einer Spannung beaufschlagbar ist sowie einen Schaltkontakt 1. Darüber hinaus umfasst die Schaltungsanordnung 10 eine in den Strompfad P1 in Serie mit dem Schaltkontakt 1 geschaltete Auswerte- und Steuereinheit 200 zur Ansteuerung der elektromechanischen Schaltvorrichtung 100 und zur Auswertung eines durch den Schaltkontakt 1 der elektromechanischen Schaltvorrichtung 100 fließenden Schaltstroms I_{Schalt}. Dabei ist die Auswerte- und Steuereinheit 200 derart eingerichtet, dass während einer Betriebsphase zur Erkennung des Schaltzustands des Schaltkontakts 1 der Schaltkontakt 1 mit einem als getaktetes Stromsignal ausgebildeten Schaltstrom I_{Schalt} beaufschlagbar ist und der Schaltstrom I_{Schalt} analysierbar ist, dahingehend, ob der Schaltkontakt 1 sich in einem geschlossen Schaltzustand befindet oder ob der Schaltkontakt 1 sich in einem geöffneten Schaltzustand befindet. Das hierfür mittels einer Taktsignalerzeugungseinrichtung 201 erzeugte Testsignal S_{Test} ist dabei als Rechtecksignal ausgebildet und hat im dargestellten Beispiel etwa ein Puls-Pausen-Verhältnis von 1:1. Während der Pulsphase wird dafür ein vorbestimmter maximaler Schaltstrom I_{Schalt_on} als sogenanntes high-Signal H geschaltet und während der Pausenphase T_{off} ein vorbestimmter minimaler Schaltstrom I_{Schalt_off}, etwa in Form eines Nullsignals (sog. Low-Signal L), insbesondere wird ein minimaler Schaltstrom I_{Schalt_off} von 0 mA geschaltet, so dass die Verlustleistung währen der Betriebsphase der Zustandserkennung des Schaltkontakts 1 entsprechend reduziert wird.

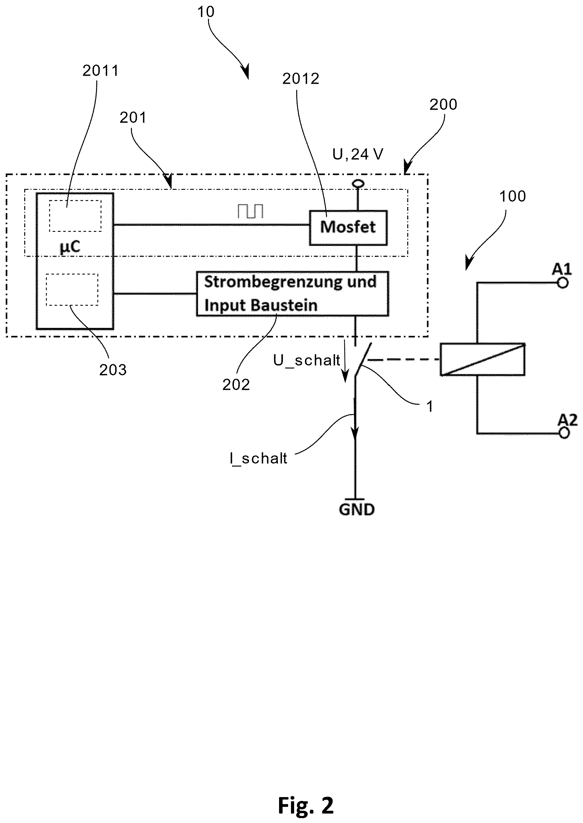

Beträgt beispielsweise die Schaltspannung und der Schaltstrom für ein 24V Relais mit Goldkontakten 24V und 1mA, resultiert daraus eine benötigte Leistung - bei einem dauerhaft angelegten (nicht getakteten) Signal - von 24V * 1mA = 24mW. Bei einem getakteten Testsignal mit einem Puls-Pause Verhältnis von 1:1 (50%) betrüge die Verlustleistung lediglich 25V * 1mA * 0,5 = 12mW (50%). Das Puls-Pausen-Verhältnis und die Periodendauer werden je nach Anwendungsfall angepasst und können im Betrieb situationsbedingt verschiedene Werte annehmen. Beispielhafter Ablauf nach Figur 2:
- Microcontroller-Taktungsausgang (Steuereinheit 2011) aktiv
- MOSFET (Halbleiterschalter 2012) schaltet 24 V zu
- Wenn der Schaltkontakt 1 des Relais (elektromechanische Schaltvorrichtung 100) geschlossen ist, erfolgt ein Stromfluss durch Eingangsbaustein (Koppeleinheit 202) und den Schaltkontakt 1.
   Microcontroller-Inputbaustein tastet ab, ob ein high-Signal H oder ein low-Signal L (wenn Kontakt geschlossen H, sonst L) anliegt.
- Microcontroller-Taktungsausgang (Steuereinheit 2011) inaktiv.
- MOSFET (Halbleiterschalter 2012) sperrt.

Dies ist der wesentliche Ablauf innerhalb eines Schaltzyklus.

Figur 2 zeigt eine im Vergleich zur Ausführungsform gemäß Figur 1 modifizierte Ausgestaltung einer Schaltungsanordnung 10 zur Erkennung des Schaltzustands eines Schaltkontakts 1 einer elektromechanischen Schaltvorrichtung 100 in schematischer Darstellung. Im Unterschied zur Ausführungsform gemäß Figur 1 ist ein konkreter Aufbau einer Schaltungsanordnung 10 gezeigt, bei welchem eine Auswerte- und Steuereinheit 200 einen Mikrocontroller aufweist, der die Funktionalität einer Steuereinheit 2011 zur Erzeugung eines getakteten Ansteuersignals zur Ansteuerung bzw. Schaltung eines als MOSFET oder dergleichen ausgebildeten Halbleiterschalters 2012 aufweist. Dabei ist zwischen Halbleiterschalter 2012 und Schaltkontakt 1 eine Koppeleinheit 202 geschaltet, die im Wesentlichen die Funktionalität einer Strombegrenzung, sowie die Funktionalität der Signalerkennung und -Weiterleitung in sich vereint. Während einer Betriebsphase der Schaltzustandserkennung der Schaltkontakte 1 wird ein entsprechendes Ansteuersignal für den Halbleiterschalterschalter 2012 erzeugt, so dass über diesen ein entsprechend getaktetes Signal im gemeinsamen Strompfad mit dem Schaltkontakt 1 erzeugt wird - bzw. der Strompfad korrespondierend zu dem Ansteuersignal des Halbleiterschalters 2012 entsprechend geschlossen und unterbrochen wird. Ist der Schaltkontakt 1 entsprechend geschlossen, wird dieser mit einem entsprechend getakteten Schaltstrom beaufschlagt und ein in seiner Verlustleistung reduzierter Schaltstrom I_{Schalt} durch die Koppeleinheit 202 erkannt und an die Auswerteeinheit 203 im Mikrocontroller zur entsprechenden Analyse weitergeleitet. Ist der Schaltkontakt 1 entsprechend geöffnet und der gemeinsame Signalpfad P1 damit unterbrochen wird entsprechend kein Schaltstrom I_{Schalt} von der Koppeleinheit 202 erfasst und diese Information an die Auswerteeinheit 203 innerhalb des Mikrocontrollers zur entsprechenden Analyse weitergeleitet.

Die Erfindung ist nicht auf die in den Figuren dargestellten Ausführungsformen beschränkt. Die vorstehende Beschreibung ist daher nicht als beschränkend, sondern als erläuternd anzusehen. Die nachfolgenden Patentansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Patentansprüche und die vorstehende Beschreibung 'erste' und 'zweite' Merkmal definieren, so dient diese Bezeichnung der Unterscheidung zweier gleichartiger Merkmale, ohne eine Rangfolge festzulegen.

### Bezugszeichenliste

1 Schaltkontakt
10 Schaltungsanordnung
100 elektromechanische Schaltvorrichtung
200 Auswerte- und Steuereinheit
201 Taktsignalerzeugungseinrichtung
2011 Steuereinheit
2012 Halbleiterschalter
202 Koppeleinheit
203 Auswerteeinheit
U_{Schalt} Schaltspannung (über Schaltkontakt)
I_{Schalt} Schaltstrom (durch Schaltkontakt)
T_{Periode} Periodendauer (Ansteuersignal bzw. Schaltsignal)

## Patentansprüche

1. Verfahren zur Erkennung des Schaltzustands eines zumindest ein Kontaktpaar aufweisenden Schaltkontakts (1) einer elektromechanischen Schaltvorrichtung (100), wobei während einer Betriebsphase zur Erkennung des Schaltzustands
- der Schaltkontakt (1) mit einem Schaltstrom (I_{Schalt}) beaufschlagt wird, und
- der Schaltstrom (I_{Schalt}) mittels einer Auswerteeinheit (2) analysiert wird, dahingehend, ob der Schaltkontakt (1) sich in einem geschlossen Schaltzustand oder in einem geöffneten Schaltzustand befindet,
dass der Schaltkontakt (1) mit einem Schaltstrom (I_{Schalt}), der als getaktetes Spannungs- oder Stromsignal ausgebildet ist, beaufschlagt wird,
**dadurch gekennzeichnet, dass**
der Schaltkontakt (1) mit einem Schaltstrom (I_{Schalt}), der als getaktetes Rechtecksignal mit einem variierbaren Puls-Pausen-Verhältnis ausgebildet ist, beaufschlagt wird.

2. Verfahren nach Anspruch 1,
**dadurch gekennzeichnet, dass**
der Schaltkontakt (1) mit einem Schaltstrom (I_{Schalt}), der als getaktetes Rechtecksignal ausgebildet ist, beaufschlagt wird, wobei während der Pulsphase (Tₒₙ) ein vorbestimmter maximaler Schaltstrom (I_{Schalt_on}) geschaltet wird und wobei während der Pausenphase (T_{off}) ein vorbestimmter minimaler Schaltstrom (I_{Schalt_off}), insbesondere ein minimaler Schaltstrom (I_{Schalt-off}) von 0 mA geschaltet wird.

3. Verfahren nach Anspruch 1,
**dadurch gekennzeichnet, dass**
das Puls-Pausen-Verhältnis in Abhängigkeit von zumindest einem Betriebsparameter variiert wird.

4. Verfahren nach einem der vorstehenden Ansprüche 1-3,
**dadurch gekennzeichnet, dass**
das Puls-Pausen-Verhältnis voreingestellt wird, derart, dass verschiedene Geschwindigkeiten zur Erkennung des Schaltzustands des Schaltkontaktes (1) vorgebbar sind.

5. Verfahren nach einem der vorstehenden Ansprüche,
**dadurch gekennzeichnet, dass**
die Periodendauer (T_{periode}) in Abhängigkeit von zumindest einem Betriebsparameter variiert wird.

6. Verfahren nach einem der vorstehenden Ansprüche,
**dadurch gekennzeichnet, dass**
bevor der Schaltkontakt (1) mit einem Schaltstrom (I_{Schalt}), der als getaktetes Stromsignal ausgebildet ist, beaufschlagt wird, der Schaltkontakt (1) über eine vorbestimmte Freibrennzeit mit einem nicht getakteten Schaltstrom (I_{Schalt}) fester Größe beaufschlagt wird.

7. Schaltungsanordnung (10) zur Erkennung des Schaltzustands eines Schaltkontakts (1) einer elektromechanischen Schaltvorrichtung (100),
umfassend
- eine elektromechanische Schaltvorrichtung (100) mit zumindest einem Schaltkontakt (1), sowie
- eine Auswerte- und Steuereinheit (200) zur Ansteuerung der elektromechanischen Schaltvorrichtung (100) und zur Auswertung eines durch den Schaltkontakt (1) der elektromechanischen Schaltvorrichtung (100) fließenden Schaltstroms (I_{Schalt}),
wobei die Auswerte- und Steuereinheit (200) derart eingerichtet ist, dass in während einer Betriebsphase zur Erkennung des Schaltzustands des Schaltkontakts (1) der Schaltkontakt (1) mit einem als getaktetes Stromsignal ausgebildeten Schaltstrom (I_{schalt}) beaufschlagbar ist, und der Schaltstrom (I_{Schalt}) analysierbar ist, dahingehend, ob der Schaltkontakt (1) sich in einem geschlossenen Schaltzustand oder in einem geöffneten Schaltzustand befindet,
**dadurch gekennzeichnet, dass**
der Schaltkontakt (1) mit einem Schaltstrom (I_{Schalt}), der als getaktetes Rechtecksignal mit einem variierbaren Puls-Pausen-Verhältnis ausgebildet ist, beaufschlagt wird.

8. Schaltungsanordnung (10) nach Anspruch 7,**dadurch gekennzeichnet, dass**
- die Auswerte- und Steuereinheit (200) umfasst:
- eine Taktsignalerzeugungseinrichtung (201),
- eine Koppeleinheit (202), und
- eine Auswerteeinheit (203),
wobei der Schaltkontakt (1) der elektromechanischen Schaltvorrichtung (100) in einem gemeinsamen Pfad (P1) zwischen einem Schaltspannungspotential (U) und Masse (GND) mit der Taktsignalerzeugungseinrichtung (201) und der Koppeleinheit (202) in Serie geschaltet ist, und
wobei die Schaltungsanordnung (10) derart eingerichtet ist, dass in einem Betriebszyklus zur Erkennung des Schaltzustands des Schaltkontakts (1) der Schaltkontakt (1) mit einem als getaktetes Stromsignal ausgebildeten Schaltstrom (I_{Schalt}) beaufschlagbar ist, und der im gemeinsamen Pfad (P1) fließende Schaltstrom (I_{Schalt}) mittels der Auswerteeinheit (203) analysierbar ist, dahingehend, ob der Schaltkontakt (1) sich in einem geschlossen Schaltzustand oder in einem geöffneten Schaltzustand befindet.

9. Schaltungsanordnung (10) nach Anspruch 7 oder 8,
**dadurch gekennzeichnet, dass**
die Taktsignalerzeugungseinrichtung (201) eine Steuereinheit (2011) und einen über die Steuereinheit (2011) ansteuerbaren Halbleiterschalter (2012) umfasst.

10. Schaltungsanordnung (10) nach einem der vorstehenden Ansprüche 7-9,
**dadurch gekennzeichnet, dass**
die Koppeleinheit (202) eingerichtet ist eine Strombegrenzung im Pfad (P1) sicherzustellen und den über den Schaltkontakt (1) fließenden getakteten Schaltstrom (I_{Schalt}) oder die über dem Schaltkontakt (1) anliegende Spannung (U_{Schalt}) zu erfassen und der Auswerteeinheit (203) zuzuführen.

## Claims

1. A method for detecting the switching state of at least one contact pair of a switching contact (1) of an electromechanical switching device (100), wherein during an operational phase for detecting the switching state
- the switching contact (1) is applied with a switching current (I_Schalt), and
- the switching current (I_Schalt) is analyzed by means of an evaluation unit (2) as to whether the switching contact (1) is in a closed switching state or in an open switching state,
that the switching contact (1) is applied with a switching current (I_Schalt) which is formed as a pulsed voltage or current signal,
**characterized in that**
the switching contact (1) is applied with a switching current (I_Schalt), which is formed as a pulsed square-wave signal with a variable pulse-pause ratio.

2. The method according to claim 1,
**characterized in that**
the switching contact (1) is applied with a switching current (I_Schalt), which is formed as a pulsed square-wave signal, wherein during the pulse phase (T_on) a predetermined maximum switching current (I_Schalt_on) is switched, and wherein during the pause phase (T_off) a predetermined minimum switching current (I_Schalt_off), in particular a minimum switching current (I_Schalt_off) of 0 mA, is switched.

3. The method according to claim 1,
**characterized in that**
the pulse-pause ratio is varied depending on at least one operating parameter.

4. The method according to any one of the preceding claims 1-3,
**characterized in that**
the pulse-pause ratio is preset such that different speeds for detecting the switching state of the switching contact (1) can be specified.

5. The method according to any one of the preceding claims,
**characterized in that**
the period duration (T_periode) is varied depending on at least one operating parameter.

6. The method according to any one of the preceding claims,
**characterized in that**
before the switching contact (1) is applied with a switching current (I_Schalt), which is formed as a pulsed current signal, the switching contact (1) is applied with a non-pulsed switching current (I_Schalt) of fixed magnitude for a predetermined burn-off time.

7. A circuit arrangement (10) for detecting the switching state of a switching contact (1) of an electromechanical switching device (100),
comprising
- an electromechanical switching device (100) with at least one switching contact (1), and
- an evaluation and control unit (200) for driving the electromechanical switching device (100) and for analyzing a switching current (I_Schalt) flowing through the switching contact (1) of the electromechanical switching device (100),
wherein the evaluation and control unit (200) is arranged such that, during an operational phase for detecting the switching state of the switching contact (1), the switching contact (1) can be applied with a switching current (I_Schalt) which is formed as a pulsed current signal, and the switching current (I_Schalt) can be analyzed to determine whether the switching contact (1) is in a closed switching state or in an open switching state,
**characterized in that**
the switching contact (1) is applied with a switching current (I_Schalt), which is formed as a pulsed square-wave signal with a variable pulse-pause ratio.

8. The circuit arrangement (10) according to claim 7,
**characterized in that**
- the evaluation and control unit (200) comprises:
- a clock-signal generating device (201),
- a coupling unit (202), and
- an evaluation unit (203),
wherein the switching contact (1) of the electromechanical switching device (100) is connected in series in a common path (P1) between a switching voltage potential (U) and ground (GND) with the clock-signal generating device (201) and the coupling unit (202), and
wherein the circuit arrangement (10) is arranged such that, in an operational cycle for detecting the switching state of the switching contact (1), the switching contact (1) can be applied with a switching current (I_Schalt) which is designed as a pulsed current signal, and the switching current (I_Schalt) flowing in the common path (P1) can be analyzed by the evaluation unit (203) to determine whether the switching contact (1) is in a closed switching state or in an open switching state.

9. The circuit arrangement (10) according to claim 7 or 8,
**characterized in that**
the clock-signal generating device (201) comprises a control unit (2011) and a semiconductor switch (2012) that can be driven via the control unit (2011).

10. The circuit arrangement (10) according to any one of the preceding claims 7-9,
**characterized in that**
the coupling unit (202) is configured to ensure a current limitation in the path (P1) and to detect the pulsed switching current (I_Schalt) flowing through the switching contact (1) or the voltage (U_Schalt) present across the switching contact (1) and to supply it to the evaluation unit (203).

## Revendications

1. Procédé pour la détection de l'état de commutation d'un contact de commutation (1) d'un dispositif de commutation électromécanique (100), présentant au moins une paire de contacts, où, pendant une phase de fonctionnement pour la détection de l'état de commutation
- le contact de commutation (1) est appliqué par un courant de commutation (I_Schalt), et
- le courant de commutation (I_Schalt) est analysé au moyen d'une unité d'évaluation (2), afin de déterminer si le contact de commutation (1) se trouve dans un état de commutation fermé ou dans un état de commutation ouvert,
qu'on applique le contact de commutation (1) par un courant de commutation (I_Schalt), qui est formé comme un signal de tension ou de courant cadencé,
**caractérisé en ce que**
le contact de commutation (1) est appliqué par un courant de commutation (I_Schalt), qui est formé comme un signal rectangulaire cadencé avec un rapport cyclique (impulsion-pause) variable.

2. Procédé selon la revendication 1,
**caractérisé en ce que**
le contact de commutation (1) est appliqué par un courant de commutation (I_Schalt), qui est formé comme un signal rectangulaire cadencé, où, pendant la phase d'impulsion (T_on), un courant de commutation maximal (I_Schalt_on) prédéterminé est commuté, et où, pendant la phase de pause (T_off), un courant de commutation minimal (I_Schalt_off) prédéterminé, en particulier un courant de commutation minimal (I_Schalt_off) de 0 mA, est commuté.

3. Procédé selon la revendication 1,
**caractérisé en ce que**
le rapport cyclique (impulsion-pause) est modifié en fonction d'au moins un paramètre de fonctionnement.

4. Procédé selon l'une des revendications précédentes 1 à 3,
**caractérisé en ce que**
le rapport cyclique (impulsion-pause) est prédéfini de sorte que différentes vitesses pour la détection de l'état de commutation du contact de commutation (1) puissent être spécifiées.

5. Procédé selon l'une des revendications précédentes,
**caractérisé en ce que**
la durée de période (T_periode) est modifiée en fonction d'au moins un paramètre de fonctionnement.

6. Procédé selon l'une des revendications précédentes,
**caractérisé en ce que**,
avant que le contact de commutation (1) soit appliqué par un courant de commutation (I_Schalt), qui est formé comme un signal de courant cadencé, le contact de commutation (1) est appliqué, pendant un temps de brûlage prédéterminé, par un courant de commutation (I_Schalt) non cadencé de grandeur fixe.

7. Agencement de circuit (10) pour la détection de l'état de commutation d'un contact de commutation (1) d'un dispositif de commutation électromécanique (100), comprenant
- un dispositif de commutation électromécanique (100) avec au moins un contact de commutation (1), ainsi que
- une unité d'évaluation et de commande (200) pour la commande du dispositif de commutation électromécanique (100) et pour l'évaluation d'un courant de commutation (I_Schalt) circulant à travers le contact de commutation (1) du dispositif de commutation électromécanique (100),
où l'unité d'évaluation et de commande (200) est configurée pour que, pendant une phase de fonctionnement pour la détection de l'état de commutation du contact de commutation (1), le contact de commutation (1) puisse être appliqué par un courant de commutation (I_Schalt), qui est formé comme un signal de courant cadencé, et que le courant de commutation (I_Schalt) puisse être analysé afin de déterminer si le contact de commutation (1) se trouve dans un état de commutation fermé ou dans un état de commutation ouvert,
**caractérisé en ce que**
le contact de commutation (1) est appliqué par un courant de commutation (I_Schalt), qui est formé comme un signal rectangulaire cadencé avec un rapport cyclique (impulsion-pause) variable.

8. Agencement de circuit (10) selon la revendication 7,
**caractérisé en ce que**
- l'unité d'évaluation et de commande (200) comprend :
- un dispositif de génération de signal cadencé (201),
- une unité de couplage (202), et
- une unité d'évaluation (203),
où le contact de commutation (1) du dispositif de commutation électromécanique (100) est connecté en série, dans un chemin commun (P1) entre un potentiel de tension de commutation (U) et la masse (GND), avec le dispositif de génération de signal cadencé (201) et l'unité de couplage (202), et
où l'agencement de circuit (10) est configuré pour que, dans un cycle de fonctionnement pour la détection de l'état de commutation du contact de commutation (1), le contact de commutation (1) puisse être appliqué par un courant de commutation (I_Schalt), qui est formé comme un signal de courant cadencé, et que le courant de commutation (I_Schalt) circulant dans le chemin commun (P1) puisse être analysé, au moyen de l'unité d'évaluation (203), afin de déterminer si le contact de commutation (1) se trouve dans un état de commutation fermé ou dans un état de commutation ouvert.

9. Agencement de circuit (10) selon la revendication 7 ou 8,
**caractérisé en ce que**
le dispositif de génération de signal cadencé (201) comprend une unité de commande (2011) et un commutateur à semiconducteur (2012) pouvant être commandé via l'unité de commande (2011).

10. Agencement de circuit (10) selon l'une des revendications précédentes 7 à 9,
**caractérisé en ce que**
l'unité de couplage (202) est configurée pour assurer une limitation de courant dans le chemin (P1) et pour détecter le courant de commutation (I_Schalt) cadencé traversant le contact de commutation (1) ou la tension (U_Schalt) appliquée au contact de commutation (1), et pour la fournir à l'unité d'évaluation (203).
